# EUROPÄISCHE PATENTSCHRIFT

(11) **EP 1 405 372 B1**
(45) Veröffentlichungstag und Bekanntmachung des Hinweises auf die Patenterteilung: **07.12.2005**
(21) Anmeldenummer: 02730224.9
(22) Anmeldetag: 29.04.2002
(51) Int. Cl.: H01R 4/00, H01L 41/047

(54) **WEITERKONTAKTIERUNG FÜR EIN PIEZOELEKTRISCHES BAUTEIL IN VIELSCHICHTBAUWEISE**
ADDITIONAL CONTACT FOR AN ELECTRIC COMPONENT AND PIEZOELECTRIC COMPONENT IN THE FORM OF A MULTILAYER STRUCTURE
SYSTEME DE CONTACT SUPPLEMENTAIRE POUR UN COMPOSANT ELECTRIQUE ET COMPOSANT PIEZO-ELECTRIQUE A STRUCTURE MULTICOUCHE

(30) Priorität: 29.06.2001 DE 10131621
(43) Veröffentlichungstag der Anmeldung: 07.04.2004
(73) Patentinhaber: SIEMENS AKTIENGESELLSCHAFT, 80333 München (DE); EPCOS AG, 81541 München (DE)
(72) Erfinder: CRAMER, Dieter, 81827 München (DE); HAHN, Iris, 85579 Neubiberg (DE); SCHUH, Carsten, 85598 Baldham (DE); STEINKOPFF, Thorsten, 85614 Eglharting (DE); WOLFF, Andreas, 81825 München (DE)
(74) Vertreter: Berg, Peter
(86) Internationale Anmeldenummer: PCT/EP2002/004723
(87) Internationale Veröffentlichungsnummer: WO 2003/005490

(56) Entgegenhaltungen:
- WO-A-00/63980
- WO-A-92/05592
- DE-A- 19 715 487
- DE-A- 19 930 585
- US-A- 6 144 142

## Beschreibung

Die vorliegende Erfindung betrifft zunächst eine Weiterkontaktierung für ein elektrisches Bauteil, insbesondere für ein piezoelektrisches Bauteil in Vielschichtbauweise gemäß dem Oberbegriff von Patentanspruch 1. Weiterhin betrifft die Erfindung ein piezoelektrisches Bauteil in Vielschichtbauweise gemäß dem Oberbegriff von Patentanspruch 8.

Piezoelektrische Bauteile können als Vielschichtbauelemente mit einer Anzahl von jeweils alternierend angeordneten piezoelektrischen Keramikschichten und Elektrodenschichten ausgebildet sein und gewinnen in der modernen Elektrotechnik immer mehr an Bedeutung. Beispielsweise werden piezoelektrische Bauteile in Form von Piezoaktoren als Stellantriebe, in Verbindung mit Ventilen und dergleichen eingesetzt.

Ein bekannter Piezoaktor ist beispielsweise in der DE 196 46 676 C1 beschrieben. Bei derartigen Piezokeramiken wird der Effekt ausgenutzt, daß diese sich unter einem mechanischen Druck, beziehungsweise Zug, aufladen und andererseits bei Anlegen einer elektrischen Spannung entlang der Hauptachse der Keramikschicht ausdehnen. Zur Vervielfachung der nutzbaren Längenausdehnung werden beispielsweise monolithische Vielschichtaktoren verwendet, die aus einem gesinterten Stapel dünner Folien aus Piezokeramik (beispielsweise Bleizirkonattitanat) mit eingelagerten metallischen Elektrodenschichten bestehen. Die Elektrodenschichten sind wechselseitig aus dem Stapel herausgeführt und über Außenmetalliserungen elektrisch parallel geschaltet. Auf den beiden Kontaktseiten des Stapels ist hierzu jeweils eine streifen- oder bandförmige, durchgängige Metallisierung aufgebracht, die mit allen Elektrodenschichten gleicher Polarität verbunden ist. Zwischen der Metallisierung und weiteren elektrischen Anschlußelementen des piezoelektrischen Bauteils ist häufig noch eine in vielen Formen ausführbare Weiterkontaktierung vorgesehen. Legt man eine elektrische Spannung an die elektrischen Anschlußelemente an, so dehnen sich die Piezofolien in Feldrichtung aus. Durch die mechanische Serienschaltung der einzelnen Piezofolien wird die Nenndehnung des gesamten Stapels schon bei relativ niedrigen elektrischen Spannungen erreicht.

Derartige Aktoren sind durch den mechanischen Hub einer erheblichen Belastung ausgesetzt. Von entscheidender Bedeutung für die Lebensdauer der Aktoren im dynamischen Betrieb ist, zur Erzielung hoher Zyklenzahlen und hoher Zuverlässigkeit, die elektrische Außenkontaktierung. Diese kann beispielsweise derart realisiert werden, daß an die Metallisierungen jeweils eine Weiterkontaktierung angebracht wird, die beispielsweise als mit Kupfer kaschierte Kaptonfolie ausgebildet sein kann. Eine solche Weiterkontaktierung wird auch als Kontaktfahne bezeichnet. Diese Weiterkontaktierung kann in ihrer gesamten Länge über ein geeignetes Verbindungsmittel, beispielsweise über Laserlötung oder dergleichen, mit der jeweils ihr zugeordneten Metallisierung verbunden werden. Auf diese Weise wird die elektrische Kontaktierung des piezoelektrischen Bauteils auch bei die Metallisierungen durchtrennenden Rissen, beispielsweise Polungsrissen und dergleichen, in der Aktorkeramik sichergestellt. Derartige Risse treten jedoch nicht nur in den Keramikschichten beziehungsweise den Metallisierungen auf.

Ebenso können während des Betriebs des piezoelektrischen Bauteils Risse auch in der Weiterkontaktierung auftreten. Die unvermeidliche Ausbreitung von Rissen in der Weiterkontaktierung, beziehungsweise in der Kontaktfahne, während des Betriebs des piezoelektrischen Bauteils wird durch eine Vielzahl von Parametern bestimmt. Die Breite der Weiterkontaktierung sowie die designtechnische Auslegung muß sich dabei vor allem an den bevorzugten Rißausbreitungsrichtungen und den maximal entstehenden Rißlängen orientieren.

In der von der Anmelderin ebenfalls eingereichten, älteren Patentanmeldung DE 197 15 487 A1 ist ein piezoelektrische Aktor beschrieben, bei dem ein wie eingangs beschriebener Aktorstapel aus Keramikschichten und dazwischen liegenden Elektrodenschichten in einem vorgefertigten Hohlprofil eingebettet ist. Das Hohlprofil weist dazu zunächst eine zentrale Ausnehmung auf, die in etwa der Form des Piezoaktorstapels entspricht. An den Seitenwänden dieser Ausnehmung sind weiterhin zwei Schlitze vorgesehen, die zu weiteren Ausnehmungen für elektrische Anschlußelemente führen. Dabei ist nach dieser Lösung vorgesehen, daß die Schlitze einen gekrümmten Verlauf haben. Wenn nun das piezoelektrische Bauteil in das Hohlprofil eingesetzt wird, befindet sich der Aktorstapel in der zentralen Ausnehmung, während sich die elektrischen Anschlußelemente in den für sie vorgesehenen Ausnehmungen befinden. Die Verbindung zwischen den elektrischen Anschlußelementen und dem Aktorstapel erfolgt über als Folien ausgebildete Weiterkontaktierungen. Diese befinden sich innerhalb der Schlitze, so daß auch die als flexible Folien ausgebildeten Weiterkontaktierungen im eingebauten Zustand ebenfalls einen leicht gekrümmten Verlauf aufweisen.

Durch eine derartige Ausgestaltung des piezoelektrischen Aktors läßt sich jedoch die Ausbreitung von über die gesamte Fläche der Weiterkontaktierung wachsenden Rissen noch nicht vollständig unterbinden, so daß im schlimmsten Fall einzelne Aktorbereiche von der elektrischen Zuleitung abgetrennt werden könnten.

Aus der WO-A-0063980 ist ein piezoelektrisches Bauelement in Vielschichtbauweise bekannt. Zur elektrischen Kontaktierung der Innenelektroden des Bauelements ist ein Kontaktelement in Form eines gebogenen und strukturierten Blechs (Doppelkamm) vorhanden.

Aus der WO-A-9205592 geht ein piezoelektrisches Bauelement mit einer gebogenen Elektrode hervor. Die Elektrode fungiert als Innenelektrode des piezoelektrischen Bauelements zum Einkoppeln eines elektrischen Feldes in eine piezoelektrische Schicht. Gleichzeitig stellt die Elektrode ein Kontaktelement dar. Die Elektrode weist einen Winkel von etwa 180° auf.

Aus der US-A-6 144 142 geht ein piezoelektrisches Bauelement in Vielschichtbauweise mit einem gebogenen Kontaktelement zur elektrischen Kontaktierung des Bauelements hervor.

Ausgehend vom genannten Stand der Technik liegt der Erfindung die Aufgabe zu Grunde, eine Weiterkontaktierung sowie ein piezoelektrisches Bauteil der eingangs genannten Art derart weiterzubilden, daß die im Zusammenhang mit dem Stand der Technik aufgezeigten Nachteile vermieden werden können. Insbesondere soll eine fehlertolerante und im dynamischen Betrieb ermüdungsarme Weiterkontaktierung eines elektrischen Bauteils, insbesondere eines piezoelektrischen Bauteils in Vielschichtbauweise, bereitgestellt werden.

Diese Aufgabe wird erfindungsgemäß gelöst durch die Weiterkontaktierung gemäß Patentanspruch 1 sowie das piezoelektrische Bauteil in Vielschichtbauweise gemäß Patentanspruch 5. Weitere Vorteile, Merkmale, Details, Aspekte und Effekte der Erfindung ergeben sich aus den Unteransprüchen, der Beschreibung sowie den Zeichnungen. Merkmale und Details, die im Zusammenhang mit der erfindungsgemäßen Meiterkontaktierung beschrieben sind, gelten dabei selbstverständlich auch für das piezoelektrische Bauteil, und umgekehrt.

Gemäß dem ersten Aspekt der Erfindung wird eine Weiterkontaktierung für ein elektrisches Bauteil, insbesondere für ein piezoelektrisches Bauteil in Vielschichtbauweise, bereitgestellt, mit einem elektrisch leitenden Kontaktelement zur Verbindung des elektrischen Bauteils mit wenigstens einem elektrischen Anschlußelement. Die Weiterkontaktierung ist erfindungsgemäß dadurch gekennzeichnet, daß das Kontaktelement eine Form aufweist, mittels derer eine Spannungsumlagerung der kritischen Zugbelastungen erfolgt oder erfolgen kann.

Als Spannungsumlagerung wird dabei im Allgemeinen verstanden, daß zumindest ein Teil der kritischen Zugbelastungen (beispielsweise in Längsrichtung des elektrischen Bauteils) in bestimmten Bereichen des Kontaktelements in andere Richtungen umgelenkt wird.

Dies soll anhand eines nicht ausschließlichen Beispiels erläutert werden. Beispielsweise ist es denkbar, daß das Kontaktelement eine Form aufweist, bei der auf derjenigen Seite des Kontaktelements, wo dieses mit dem elektrischen Bauteil verbunden ist, volle Zugbelastung herrscht, während im Kontaktelement in demjenigen Bereich, in dem es beispielsweise mit einem elektrischen Anschlußelement verbunden wird (freier Bereich), Spannungen anderer Richtungen vorherrschen.

Durch die erfindungsgemäße Ausgestaltung der Weiterkontaktierung kann eine fehlertolerante und im dynamischen Betrieb ermüdungsarme elektrische Verbindung des elektrischen Bauteils mit wenigstens einem elektrischen Anschlußelement sichergestellt werden.

Dazu weist die Weiterkontaktierung, und hier insbesondere deren elektrisch leitendes Kontaktelement nunmehr eine ganz spezielle Form auf. Dadurch wird eine zuverlässige Kontaktierung des elektrischen Bauteils bei gleichzeitig reduzierter mechanischer Spannungsbelastung ermöglicht. Ein Grundgedanke der Erfindung ist daher eine besondere Auslegung der Weiterkontaktierung, bei der es sich um ein entscheidendes Bindeglied zwischen dem elektrischen Bauteil und wenigstens einem weiteren elektrischen Anschlußelement, beispielsweise einem Stecker, einem Kontaktstift oder dergleichen, handelt.

Erfindungsgemäß ist nunmehr vorgesehen, daß das Kontaktelement der Weiterkontaktierung eine solche Form aufweist, mittels derer kritische Belastungen, beispielsweise kritische Zug-/Druckbelastungen, bei denen es sich im Falle eines piezoelektrischen Bauteils in Vielschichtbauweise, beispielsweise eines Aktors, um Wechselbelastungen handelt, derart reduziert werden können, daß die im Kontaktelement auftretenden Risse nicht mehr zu den im Stand der Technik beschriebenen Nachteilen führen. Dazu ist die Weiterkontaktierung erfindungsgemäß derart ausgestaltet, daß nunmehr eine Spannungsumlagerung der kritischen Belastungen, insbesondere der kritischen Zugbelastungen erfolgt oder erfolgen kann, wodurch die Ermüdungsrißausbreitung verlangsamt wird und innerhalb des Kontaktelements gestoppt werden kann. Dadurch kann die Lebensdauer des mit der erfindungsgemäßen Weiterkontaktierung versehenen elektrischen Bauteils erhöht werden.

Die Erfindung ist nicht auf bestimmte Ausgestaltungsformen für die Weiterkontaktierung beschränkt. Einige nicht ausschließliche Beispiele werden im weiteren Verlauf der Beschreibung näher erläutert.

Vorteilhaft kann die Ausgestaltung des Kontaktelements derart gewählt werden, daß gleichzeitig eine Spannungsverringerung in den vom elektrischen Bauteil entfernten Bereichen des Kontaktelements, beispielsweise der Kontaktfahne, erreicht wird.

Vorzugsweise kann das Kontaktelement wenigstens eine Vorverformung, insbesondere eine Umbiegung, aufweisen. Dadurch können insbesondere die für das Ermüdungsverhalten des Kontaktelements schädlichen mechanischen Zug-/Druckbelastungen besonders vorteilhaft umgelagert werden, insbesondere bei gleichzeitiger Spannungsverringerung im Kontaktelement.

Als "Vorverformung" wird dabei jede Art von Verformung verstanden, die zu einer - insbesondere bleibenden - Formänderung des Kontaktelements führt, bevor dieses am elektrischen Bauteil angeordnet wird.

Im Unterschied dazu weist das in der DE 197 15 487 A1 beschriebene piezoelektrische Bauteil eine Weiterkontaktierung auf, die lediglich einen gekrümmten Verlauf hat. Diese bekannte Weiterkontaktierung, die aus einer dünnen Folie hergestellt ist, weist jedoch keine Vorverformung (Umbiegung) auf. Wenn die Folie in die gekrümmten Schlitze eingelegt wird, nimmt sie lediglich einen gekrümmten Verlauf an. Allerdings bleibt die Folie dabei nachwievor unverformt. Wenn die in der bekannten Lösung offenbarte Weiterkontaktierung aus den entsprechenden Schlitzen herausgenommen wird, wird sie auf Grund ihrer Elastizität ihre Ausgangsform wieder einnehmen. Bei dieser Ausgangsform handelt es sich um eine ebene Fläche ohne jegliche Verformung.

Gerade die Vorverformung (Umbiegung) des Kontaktelements führt jedoch dazu, daß die erfindungsgemäße Spannungsumlagerung der kritischen Zugbelastungen erfolgen kann.

In weiterer Ausgestaltung kann das Kontaktelement einen Kontaktierbereich zur Verbindung mit wenigstens einem elektrischen Anschlußelement und einen Befestigungsbereich zur Verbindung mit einem elektrischen Bauteil aufweisen. Vorteilhaft kann das Kontaktelement im Befestigungsbereich wenigstens eine Vorverforumng, insbesondere eine Umbiegung, aufweisen. Auf diese Weise wird es möglich, daß bei der Umlagerung der für das Ermüdungsverhalten des Kontaktelemente schädlichen mechanischen Zug-/Druckbelastungen gleichzeitig auch die Spannung in den vom elektrischen Bauteil entfernten Bereichen des Kontaktelements verringert werden kann. Dadurch kann die Ermüdungsrißausbreitung im Kontaktelement verlangsamt und in der ersten Hälfte des Kontaktelements gestoppt werden. Dadurch wird die Lebensdauer des gesamten elektrischen Bauteils deutlich erhöht, da es auf Grund der Risse im Kontaktelement nicht mehr zur Abtrennung einzelner Bereiche des elektrischen Bauteils von der elektrischen Zuleitung kommen kann, wie dies im Rahmen der Beschreibungseinleitung bei den bisher bekannten Lösungen dargelegt wurde.

Ebenso ist denkbar, daß im Befestigungsbereich oder aber in beiden Bereichen wenigstens eine Vorverformung, insbesondere eine Umbiegung, vorgesehen ist.

Vorteilhaft kann das Kontaktelement zumindest bereichsweise eine Strukturierung aufweisen. Durch eine solche Strukturierung des Kontaktelements kann die Rißausbreitung in diesem weiter verlangsamt beziehungsweise gestoppt werden. Durch die zumindest bereichsweise Strukturierung des Kontaktelements können die mechanischen Spannungen im Kontaktelement während des Betriebs des elektrischen Bauteils minimiert werden.

Wenn es sich bei dem elektrischen Bauteil beispielsweise um ein piezoelektrisches Bauteil in Vielschichtbauweise handelt, sind solche mechanischen Spannungen dann besonders groß, wenn im piezoelektrisch inaktiven Bereich des Bauteils ein Riß, beispielsweise durch eine Polarisierung des piezoelektrischen Bauteils (Polungsriß) entstanden ist. Bei der Elongation und der Kontraktion findet bei einem solchen Riß eine relativ große Änderung des Ausmaßes des piezoelektrischen Bauteils statt. Durch diese große Änderung treten große mechanische Spannungen im Kontaktelement auf, insbesondere dann, wenn das Kontaktelement mit einem starren Anschlußelement, beispielsweise einem Kontaktstift oder dergleichen, fest verbunden ist.

Durch die zumindest bereichsweise Strukturierung des Kontaktelements kann nunmehr eine Erhöhung der Flexibilität des Kontaktelements erreicht werden. Dies kann beispielsweise durch Einbringen wenigstens einer Aussparung und/oder wenigstens einer Ausdünnung in dem Kontaktelement erfolgen. Form, Größe, Plazierung und Anzahl der Aussparungen beziehungsweise Ausdünnungen sind vorteilhaft so gestaltet, daß das Kontaktelement insbesondere in Richtung der Elongation und Kontraktion des piezoelektrischen Bauteils flexibel ist. Eine Lösung, wie ein Kontaktelement vorteilhaft strukturiert werden kann, ist beispielsweise in der von der Anmelderin ebenfalls eingereichten, älteren Patentanmeldung EP 1 065 735 A2 beschrieben, deren Offenbarungsgehalt insoweit in die Beschreibung der vorliegenden Erfindung miteinbezogen wird.

Vorteilhaft kann die Weiterkontaktierung zumindest bereichsweise aus einem Metall, insbesondere einem Metall aus der Gruppe Cu, Fe, Stahl, Nickel, Kobalt, Aluminium, Beryllium, gebildet sein. Besonders vorteilhaft kann die Weiterkontaktierung aus einer Kupfer-Nickel- und/oder Aluminiumbasislegierung hergestellt sein. Von besonderem Vorteil ist eine Kupfer-Beryllium- und/oder eine Nickel-Berylliumlegierung. Diese Legierungen zeichnen sich durch eine hohe Ermüdungsfestigkeit und damit durch eine hohe mechanische Langzeitstabilität aus.

Als Material der Weiterkontaktierung sind neben Metallen nicht-metallische Leiter wie beispielsweise organische Leitermaterialien und dergleichen denkbar.

Gemäß dem zweiten Aspekt der Erfindung wird ein piezoelektrisches Bauteil in Vielschichtbauweise bereitgestellt, bei dem alternierend immer eine piezoelektrische Keramikschicht und eine Elektrodenschicht zur Bildung eines Stapels übereinander angeordnet ist und bei dem jeweils wenigstens eine erste Elektrodenschicht und wenigstens eine im Stapel darauffolgende, zur ersten Elektrodenschicht benachbarte zweite Elektrodenschicht zur elektrischen Kontaktierung in alternierender Polarität jeweils mit zumindest einer Weiterkontaktierung verbunden ist. Das piezoelektrische Bauteil ist erfindungsgemäß dadurch gekennzeichnet, daß die Weiterkontaktierung in der wie vorstehend beschriebenen erfindungsgemäßen Weise ausgebildet ist.

Auf diese Weise kann ein piezoelektrisches Bauteil mit einer zuverlässigen Weiterkontaktierung geschaffen werden, wobei ein fehlertoleranter und im dynamischen Betrieb ermüdungsarmer elektrischer Anschluß des Stapels aus Keramikschichten und Elektrodenschichten, beispielsweise an wenigstens ein elektrisches Anschlußelement, sichergestellt ist.

Vorteilhaft kann die wenigstens eine erste Elektrodenschicht und die wenigstens eine zweite Elektrodenschicht zur elektrischen Kontaktierung in alternierender Polarität jeweils mit zumindest einer seitlich am Stapel angeordneten Metallisierung verbunden sein, wobei jede Metallisierung elektrisch mit einer Weiterkontaktierung verbunden ist. Die Verbindung der Metallisierung mit der Weiterkontaktierung kann dabei über geeignete Verbindungsmittel, wie beispielsweise eine Lötverbindung, eine Schweißverbindung oder dergleichen, erfolgen. Die Erfindung ist nicht auf bestimmte Verbindungsarten zwischen Metallisierung und Weiterkontaktierung beschränkt.

Vorzugsweise kann die Weiterkontaktierung ein Kontaktelement mit einem Kontaktierbereich und einem Befestigungsbereich aufweisen, wobei das Kontaktelement über den Kontaktierbereich mit wenigstens einem elektrischen Anschlußelement verbunden ist und wobei das Kontaktelement über den Befestigungsbereich mit dem Stapel (mit den im Stapel befindlichen Elektrodenschichten gleicher Polarität), insbesondere mit der wenigstens einen Metallisierung, verbunden ist.

Vorzugsweise kann die Weiterkontaktierung zumindest bereichsweise von einem Passivierungsmaterial umgeben sein. Bei einem Passivierungsmaterial handelt es sich um eine Art Schutzmaterial und/oder Isolationsmaterial, welches beispielsweise aus einem Kunststoff gebildet sein kann. Eine elektrische Passivierung freiliegender elektrischer Bauelemente, wie beispielsweise dem Kontaktelement der Weiterkontaktierung, den in einem piezoelektrischen Bauteil befindlichen Elektrodenschichten und dergleichen, ist erforderlich, um elektrische Überschläge und Kurzschlüsse zwischen benachbarten, freiliegenden elektrischen Bauteilen zu vermeiden.

In weiterer Ausgestaltung kann der Stapel und die Weiterkontaktierung in einem einzigen Hüllkörper, vorzugsweise aus Passivierungsmaterial, angeordnet sein. Dabei wird das Kontaktelement der Weiterkontaktierung bevorzugt in der Nähe, das heißt in unmittelbarer Umgebung des Stapels liegend, mit dem Passivierungsmaterial, beispielsweise einem geeigneten Kunststoff, vergossen. Damit wird auch das Kontaktelement im dynamischen Betrieb homogen mit dem Stapel des piezoelektrischen Vielschichtbauelements mitgedehnt, wodurch mechanische Belastungen auf die Verbindungsstellen zwischen dem Kontaktelement und dem piezoelektrischen Bauteil sowie auf das Kontaktelement selbst deutlich reduziert werden. Dieser Mitführeffekt im dynamischen Betrieb wird insbesondere dadurch gewährleistet, daß der Abstand des Kontaktelements zum Stapel bewußt möglichst gering gehalten wird.

Vorteilhaft kann ein wie vorstehend beschriebenes erfindungsgemäßes piezoelektrisches Bauteil als piezoelektrischer Aktor oder als piezoelektrischer Wandler ausgebildet sein. Beispielhafte Ausführungsformen hierfür sind etwa Stapelaktoren, Transversalaktoren, Biegeaktoren, Wandler für medizinischen Ultraschall und dergleichen. Insbesondere kann das piezoelektrische Bauteil als Piezoaktor in Automobilsystemen, beispielsweise als Antrieb für Benzin- und Dieseleinspritzsysteme eingesetzt werden.

Die Erfindung wird nun an Hand von Ausführungsbeispielen unter Bezugnahme auf die beiliegende Zeichnung näher erläutert. Es zeigen:
- Figur 1: in perspektivischer Ansicht einen Teilausschnitt aus einem erfindungsgemäßen piezoelektrischen Bauteil in Vielschichtbauweise; und
- Figur 2: in perspektivischer Ansicht eine erfindungsgemäße Ausführungsform einer Weiterkontaktierung für ein elektrisches Bauteil.

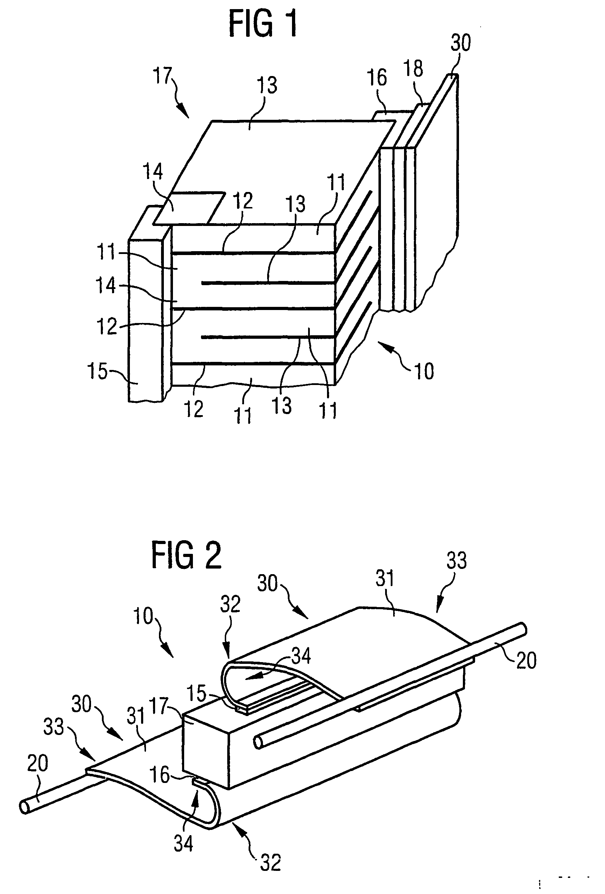

In Figur 1 ist ein als Piezoaktor ausgebildetes piezoelektrisches Bauteil 10 in Vielschichtbauweise dargestellt. Der Piezoaktor 10 bildet einen aus zahlreichen piezoelektrischen Keramikschichten 11 und Elektrodenschichten 12, 13 aufgebauten Stapel 17. Die Elektrodenschichten 12 und 13 haben dabei jeweils unterschiedliche Polarität, wobei Elektrodenschichten gleicher Polarität jeweils als erste Elektrodenschichten 12, beziehungsweise zweite Elektrodenschichten 13, bezeichnet sind. Die Elektrodenschichten 12, beziehungsweise 13, gleicher Polarität sind jeweils mit einer gemeinsamen Metallisierung 15, beziehungsweise 16, verbunden.

Erkennbar sind weiterhin inaktive Isolationszonen 14, die abwechselnd in gegenüber liegenden Ecken der aufeinander folgenden, sich in diesem Fall nicht über den gesamten Stapelquerschnitt erstreckenden Elektrodenschichten 12, 13 angeordnet sind. Dieser Aufbau ermöglicht den gemeinsamen Anschluß aller ersten Elektrodenschichten 12, beziehungsweise aller zweiten Elektrodenschichten 13, mit jeweils gleicher Polarität durch eine gemeinsame, vertikale Außenmetallisierung 15, beziehungsweise 16. Bei den Außenmetallisierungen 15, 16 kann es sich beispielsweise um ein entsprechendes Metallisierungsband handeln.

Wie im Zusammenhang mit der Metallisierung 16 dargestellt ist, ist diese über ein geeignetes Verbindungsmittel 18, bei dem es sich beispielsweise um eine Lötverbindung, eine Schweißverbindung oder dergleichen handeln kann, mit einer Weiterkontaktierung 30 verbunden. Auf ähnliche Weise kann auch die Metallisierung 15 mit einer Weiterkontaktierung (nicht dargestellt) verbunden sein.

Der Aufbau und die Ausgestaltung der Weiterkontaktierung 30 ergibt sich aus Figur 2.

In Figur 2 ist zunächst in stark vereinfachter Form der Stapel 17 des Piezoaktors 10 als "Stack" dargestellt. Der Stapel 17 verfügt an zwei sich gegenüber liegenden Seiten über die Metallisierungen 15, 16, über die der Stapel 17 mittels Weiterkontaktierungen 30 mit elektrischen Anschlußelementen 20 verbunden ist. Bei den Anschlußelementen 20 handelt es sich beispielsweise um entsprechende Kontaktstifte.

Wie aus Figur 2 zu ersehen ist, besteht die Weiterkontaktierung 30 aus einem Kontaktelement 31, bei dem es sich beispielsweise um eine Folie handeln kann. Das Kontaktelement 31 weist einen Kontaktierbereich 33 auf, über das die Verbindung mit dem elektrischen Anschlußelement 20 realisiert wird. Weiterhin verfügt das Kontaktelement 31 über einen Befestigungsbereich 34, mittels dessen es mit der Metallisierung 15, 16 verbunden wird.

Um während des Betriebs des Piezoaktors 10 auftretende, schädliche mechanische Zug-/Druck-Wecheselbelastungen, die zu Rissen in den Kontaktelementen 31 führen können, zu minimieren, weist das Kontaktelement 31 wenigstens eine Vorverformung, insbesondere eine Umbiegung 32, auf. Im vorliegenden Ausführungsbeispiel ist die wenigstens eine Umbiegung 32 im Befestigungsbereich 34 ausgebildet. Ebenso ist es denkbar, daß die wenigstens eine Umbiegung 32 auch im Kontaktierbereich 33 oder aber in beiden Bereichen ausgebildet sein könnte. Bei der Umbiegung 32 handelt es sich um eine Vorverformung des Kontaktelements 31 entlang einer Biegelinie, die durch Aufbringen eines Biegemoments, beziehungsweise einer Biegebeanspruchung, bewirkt wird. Auf Grund der Umbiegung 32 erfolgt eine Spannungsumlagerung der kritischen Zug-/Druck-Wechselbelastungen bei gleichzeitiger Spannungsverringerung in vom Stapel 17 entfernten Bereichen des Kontaktelements 31, hier im Kontaktierbereich 33. Dadurch wird die Ermüdungsrißausbreitung im Kontaktelement 31 verlangsamt und in der ersten Hälfte des Kontaktelements 31, hier im Befestigungsbereich 34, sogar gestoppt. Auf diese Weise kann die elektrische Kontaktierung des Stapels 17 auch bei die Metallisierungen 15, 16 durchtrennenden Rissen in der Aktorkeramik sowie bei auftretenden Rissen in den Weiterkontaktierungen 30 jederzeit sichergestellt werden.

Die Auswahl des für die Umbiegung 32 geeigneten Winkels ergibt sich je nach Bedarf und Anwendungsfall. Im Ausführungsbeispiel gemäß Figur 2 ist für die Umbiegung 32 ein Biegewinkel von 180° gewählt.

Durch die erfindungsgemäße Ausgestaltung der Weiterkontaktierung 30 wird ein fehlertoleranter und im dynamischen Betriebs des Piezoaktors 10 ermüdungsarmer elektrischer Anschluß des Stapels 17 an die Anschlußelemente 20 sichergestellt, was unter anderem eine der zentralen Voraussetzungen zur Gewährleistung einer für die Automobilindustrie ausreichend hohen Lebensdauer des Piezoaktors 10 ist.

## Patentansprüche

1. Weiterkontaktierung eines piezoelektrischen Bauteils in Vielschichtbauweise, mit einem elektrisch leitenden Kontaktelement (31) zur Verbindung des piezoelektrischen Bauteils (10) mit wenigstens einem elektrischen Anschlußelement (20), wobei das Kontaktelement eine Umbiegung aufweist, **dadurch gekennzeichnet, daß** das Kontaktelement als elektrisch leitende Folie ausgebildet ist und die Umbiegung einen Winkel von im Wesentlichen 180° aufweist.

2. Weiterkontaktierung nach Anspruch 1, **dadurch gekennzeichnet, daß** das Kontaktelement (31) einen Kontaktierbereich (33) zur Verbindung mit wenigstens einem elektrischen Anschlußelement (20) und einen Befestigungsbereich (34) zur Verbindung mit einem elektrischen Bauteil (10) aufweist, und daß das Kontaktelement (31) im Befestigungsbereich (34) die Umbiegung (32), aufweist.

3. Weiterkontaktierung nach Anspruche 1 oder 2, **dadurch gekennzeichnet, daß** das Kontaktelement (31) zumindest bereichsweise eine Strukturierung aufweist.

4. Weiterkontaktierung nach einem der Ansprüche 1 bis 3, **dadurch gekennzeichnet, daß** die Weiterkontaktierung zumindest bereichsweise aus einem Metall, insbesondere einem Metall aus der Gruppe Cu, Fe, Stahl, Nickel, Kobalt, Aluminium, Beryllium, gebildet ist.

5. Piezoelektrisches Bauteil in Vielschichtbauweise, bei dem alternierend immer eine piezoelektrische Keramikschicht (11) und eine Elektrodenschicht (12, 13) zur Bildung eines Stapels (17) übereinander angeordnet ist und bei dem jeweils wenigstens eine erste Elektrodenschicht (12) und wenigstens eine im Stapel (17) darauffolgende, zur ersten Elektrodenschicht benachbarte zweite Elektrodenschicht (13) zur elektrischen Kontaktierung in alternierender Polarität jeweils mit zumindest einer Weiterkontaktierung (30) verbunden ist, **dadurch gekennzeichnet , daß** die Weiterkontaktierung (30) nach einem der Ansprüche 1 bis 4 ausgebildet ist.

6. Piezoelektrisches Bauteil nach Anspruch 5, **dadurch gekennzeichnet , daß** die wenigstens eine erste Elektrodenschicht (12) und die wenigstens eine zweite Elektrodenschicht (13) zur elektrischen Kontaktierung in alternierender Polarität jeweils mit zumindest einer seitlich am Stapel (17) angeordneten Metallisierung (15, 16) verbunden ist, wobei jede Metallisierung (15, 16) elektrisch mit einer Weiterkontaktierung (30) verbunden ist.

7. Piezoelektrisches Bauteil nach Anspruch 5 oder 6, **dadurch gekennzeichnet, daß** die Weiterkontaktierung (30) ein Kontaktelement (31) mit einem Kontaktierbereich (33) und einem Befestigungsbereich (34) aufweist, daß das Kontaktelement (31) über den Kontaktierbereich (33) mit wenigstens einem elektrischen Anschlußelement (20) verbunden ist und daß das Kontaktelement (31) über den Befestigungsbereich (34) mit dem Stapel (17), insbesondere mit der wenigstens einen Metallisierung (15, 16) verbunden ist.

8. Piezoelektrisches Bauteil nach einem der Ansprüche 5 bis 7, **dadurch gekennzeichnet, daß** die Weiterkontaktierung (30) zumindest bereichsweise von einem Passivierungsmaterial umgeben ist.

9. Piezoelektrisches Bauteil nach einem der Ansprüche 5 bis 8, **dadurch gekennzeichnet, daß** der Stapel (17) und die Weiterkontaktierung (30) in einem einzigen Hüllkörper, vorzugsweise aus Passivierungsmaterial, angeordnet sind.

10. Piezoelektrisches Bauteil nach einem der Ansprüche 5 bis 9, **dadurch gekennzeichnet, daß** dieses als piezoelektrischer Aktor oder als piezoelektrischer Wandler ausgebildet ist.

## Claims

1. Additional point of contact for a piezoelectric component of multilayer construction, having an electrically conductive contact element (31) for connecting the piezoelectric component (10) to at least one electric connection element (20), where the contact element has a bend, **characterized in that** the contact element is in the form of an electrically conductive film and the bend has an angle of substantially 180°.

2. Additional point of contact according to Claim 1, **characterized in that** the contact element (31) has a contact region (33) for connection to at least one electric connection element (20) and has a mounting region (34) for connection to an electric component (10) and **in that** the contact element (31) has the bend (32) in the mounting region (34).

3. Additional point of contact according to Claims 1 or 2, **characterized in that** at least regions of the contact element (31) have a patterned portion.

4. Additional point of contact according to one of Claims 1 to 3, **characterized in that** at least regions of the additional point of contact are formed from a metal, particularly a metal from the group Cu, Fe, steel, nickel, cobalt, aluminium, beryllium.

5. Piezoelectric component of multilayer construction, in which a piezoelectric ceramic layer (11) and an electrode layer (12, 13) are always arranged alternately above one another in order to form a stack (17) and in which at least one first electrode layer (12) and at least one second electrode layer (13), which comes next in the stack (17) and is adjacent to the first electrode layer, are connected to at least one respective additional point of contact (30) for the purpose of making electric contact with alternating polarity, **characterized in that** the additional point of contact (30) is in the form according to one of Claims 1 to 4.

6. Piezoelectric component according to Claim 5, **characterized in that** the at least one first electrode layer (12) and the at least one second electrode layer (13) are connected to at least one respective metalized portion (15, 16) arranged at the side of the stack (17) in order to make electric contact with alternating polarity, each metalized portion (15, 16) being electrically connected to an additional point of contact (30).

7. Piezoelectric component according to Claim 5 or 6, **characterized in that** the additional point of contact (30) has a contact element (31) having a contact region (33) and a mounting region (34), **in that** the contact element (31) is connected to at least one electric connection element (20) by means of the contact region (33), and **in that** the contact element (31) is connected to the stack (17), particularly to the at least one metalized portion (15, 16), by means of the mounting region (34).

8. Piezoelectric component according to one of Claims 5 to 7, **characterized in that** at least regions of the additional point of contact (30) are surrounded by a passivation material.

9. Piezoelectric component according to one of Claims 5 to 8, **characterized in that** the stack (17) and the additional point of contact (30) are arranged in a single casing, preferably made of passivation material.

10. Piezoelectric component according to one of Claims 5 to 9, **characterized in that** it is in the form of a piezoelectric actuator or in the form of a piezoelectric transducer.

## Revendications

1. Connexion ultérieure d'un composant piézo-électrique à structure multicouche, comprenant un élément de contact électroconducteur (31) pour connecter le composant piézo-électrique (10) à au moins un élément de raccordement électrique (20), l'élément de contact comportant un pliage, **caractérisée en ce que** l'élément de contact est réalisé sous forme d'une feuille électroconductrice et que le pliage présente un angle sensiblement égal à 180°.

2. Connexion ultérieure selon la revendication 1, **caractérisée en ce que** l'élément de contact (31) comprend une partie de mise en contact (33) pour la connexion à au moins un élément de raccordement électrique (20), et une partie de fixation (34) pour la connexion à un composant électrique (10), et que l'élément de contact (31) comporte le pliage (32) dans la partie de fixation (34).

3. Connexion ultérieure selon la revendication 1 ou 2, **caractérisée en ce que** l'élément de contact (31) comporte au moins en partie une structuration.

4. Connexion ultérieure selon l'une des revendications 1 à 3, **caractérisée en ce que** la connexion ultérieure est formée au moins en partie d'un métal, en particulier d'un métal choisi dans le groupe formé par le cuivre, le fer, l'acier, le nickel, le cobalt, l'aluminium, et le béryllium.

5. Composant piézo-électrique à structure multicouche dans lequel une couche céramique piézo-électrique (11) et une couche d'électrode (12, 13) sont disposées en alternance l'une au-dessus de l'autre pour former une pile (17), et dans lequel au moins une première couche d'électrode (12) et au moins une deuxième couche d'électrode (13) suivante dans la pile (17) et adjacente à la première couche d'électrode sont connectées chacune afin d'établir un contact électrique, avec une polarité alternante avec, respectivement, au moins une connexion ultérieure (30), **caractérisé en ce que** la connexion ultérieure (30) est réalisée selon l'une des revendications 1 à 4.

6. Composant piézo-électrique selon la revendication 5, **caractérisé en ce qu'**au moins une première couche d'électrode (12) et la au moins deuxième couche d'électrode (13) sont reliées, afin d'établir le contact électrique avec une polarité alternante, chacune à au moins une métallisation (15, 16) disposée latéralement sur la pile (17), chaque métallisation (15, 16) étant reliée électriquement à une connexion ultérieure (30).

7. Composant piézo-électrique selon la revendication 5 ou 6, **caractérisé en ce que** la connexion ultérieure (30) comprend un élément de contact (31) présentant une partie de contact (33) et une partie de fixation (34), que l'élément de contact (31) est raccordé via la partie de contact (33) à au moins un élément de raccordement électrique (20), et que l'élément de contact (31) est connecté via la partie de fixation (34) à la pile (17), en particulier à la au moins une métallisation (15, 16).

8. Composant piézo-électrique selon l'une des revendications 5 à 7, **caractérisé en ce que** la connexion ultérieure (30) est entourée au moins en partie d'une matière de passivation.

9. Composant piézo-électrique selon l'une des revendications 5 à 8, **caractérisé en ce que** la pile (17) et la connexion ultérieure (30) sont disposées dans une seule enveloppe, de préférence fabriquée à partir d'une matière de passivation.

10. Composant piézo-électrique selon l'une des revendications 5 à 9, **caractérisé en ce que** le composant est réalisé en forme d'actionneur piézo-électrique ou de transducteur piézo-électrique.
